# EUROPEAN PATENT APPLICATION

(11) **EP 4 717 803 A1**
(43) Date of publication of application: **01.04.2026**
(21) Application number: 24811097.5
(22) Date of filing: 21.05.2024
(51) Int. Cl.: C30B 29/16, C23C 16/40, C30B 25/02, H01L 21/365

(54) **METHOD FOR PRODUCING CRYSTALLINE FILM, VAPOR PHASE GROWTH DEVICE, AND ?-GALLIUM OXIDE CRYSTALLINE FILM**

(30) Priority: 23.05.2023 JP 2023084641
(71) Applicant: Taiyo Nippon Sanso Corporation, Tokyo 142-8558 (JP); National University Corporation Tokyo University Of Agriculture and Technology, Fuchu-shi Tokyo 183-8538 (JP)
(72) Inventor: YOSHINAGA, Junya, Tokyo 142-8558 (JP); PIAO, Guanxi, Tokyo 142-8558 (JP); IKENAGA, Kazutada, Tokyo 142-8558 (JP); KUMAGAI, Yoshinao, Fuchu-shi, Tokyo 183-8538 (JP); GOTO, Ken, Fuchu-shi, Tokyo 183-8538 (JP); SASAKI, Shogo, Fuchu-shi, Tokyo 183-8538 (JP)
(74) Representative: HGF
(86) International application number: PCT/JP2024/018607
(87) International publication number: WO 2024/242090

(57) **Abstract**

A method for producing a crystalline film, including causing a plurality of feedstock gases to merge at a merging position to obtain a mixed gas containing trimethylgallium, oxygen, and a silicon dopant in argon, heating the obtained mixed gas from the merging position such that a temperature at the merging position is within a range of 850°C to 1100°C, and guiding the heated mixed gas to a surface of a substrate 2 to grow a β-gallium oxide crystalline film on the surface of the substrate 2.

## Description

### TECHNICAL FIELD

The present invention relates to a method for producing a crystalline film, a vapor phase growth device, and a β-gallium oxide crystalline film. Priority is claimed on Japanese Patent Application No. 2023-084641, filed May 23, 2023, the content of which is incorporated herein by reference.

### BACKGROUND ART

The vapor phase growth method is a thin film forming method in which gaseous raw material for the thin film is supplied onto a substrate, and the raw material is deposited on a substrate surface through a chemical reaction. For example, a gallium nitride-based semiconductor thin film serving as a material for a blue light emitting diode, a green light emitting diode, or a violet laser diode is produced by a metal organic chemical vapor deposition (MOCVD) method using an organic metal as a raw material.

As a vapor phase growth device for forming a semiconductor thin film by using a vapor phase growth method, for example, a device disclosed in Patent Document 1 is available. In the vapor phase growth device of Patent Document 1, the vicinity of the substrate is heated, but the feedstock gas flow channel is cooled by a cooling device to prevent the feedstock gas from unintentionally forming a film in the flow channel before reaching the substrate. In addition, the feedstock gas flow channel and the vicinity of the substrate are separated by an insulating plate, thereby preventing the feedstock gas flow channel from being heated together with the vicinity of the substrate.

In recent years, gallium oxide has attracted attention as a new semiconductor material. Gallium oxide has different crystal structures referred to as α, β, γ, δ, and ε types. Among these, the β type is most thermally stable.

β-gallium oxide (β-Ga₂O₃) has excellent physical properties such as a band gap of approximately 5 eV and a breakdown electric field of approximately 8 MV/cm, and it is expected to be applied to a high-voltage power devices.

In Non Patent Document 1, it is reported that a film of crystals of β-gallium oxide is formed by MOCVD.

### Citation List

### Patent Document

Patent Document 1: Japanese Patent No. 4542860

### Non Patent Document

Non Patent Document 1: F. Alema, B. Hertog, A. Osinsky, P. Mukhopadhyay, M. Toporkov, and W. V. Schoenfeld, J. Cryst. Growth 475 (2017) 77-82

### SUMMARY OF INVENTION

### Technical Problem

To realize a high-voltage power device, it is necessary to grow a high-purity β-Ga₂O₃ crystalline film. However, it has been difficult to obtain a high-purity β-Ga₂O₃ crystalline film by the conventional MOCVD method.

The present invention has been made in view of the above circumstances, and provides a method for producing a crystalline film in which a high-purity β-Ga₂O₃ crystalline film can be produced, a vapor phase growth device, and a β-gallium oxide crystalline film.

### Solution to Problem

To achieve the object, the present invention adopts the following configurations.
[1] A method for producing a crystalline film, including causing a plurality of feedstock gases to merge at a merging position to obtain a mixed gas containing trimethylgallium, oxygen, and a silicon dopant in argon and heating the obtained mixed gas from the merging position, and guiding the heated mixed gas to a substrate surface to grow a β-gallium oxide crystalline film on the substrate surface.
[2] The method for producing a crystalline film according to [1], in which the merging position is heated to a temperature of 850°C to 1100°C.
[3] The method for producing a crystalline film according to [1] or [2], in which the plurality of feedstock gases consists of a first feedstock gas containing the trimethylgallium and the silicon dopant in argon, and a second feedstock gas containing the oxygen in argon.
[4] A vapor phase growth device for forming a β-gallium oxide crystalline film by a vapor phase growth method by supplying a mixed gas containing trimethylgallium, oxygen, and a silicon dopant in argon to a substrate disposed in a reaction furnace, the vapor phase growth device including feedstock gas flow channels configured to respectively guide a plurality of feedstock gases to a merging position and a mixed gas flow channel configured to guide the mixed gas obtained at the merging position from the merging position to a substrate surface and then discharge the mixed gas, the feedstock gas flow channels and the mixed gas flow channel being formed in the reaction furnace, and a heating device configured to heat the merging position such that a temperature at the merging position is within a range of 850°C to 1100°C.
[5] The vapor phase growth device according to [4], in which the heating device is disposed around a portion of the reaction furnace surrounding the merging position.
[6] The vapor phase growth device according to [4] or [5], in which the feedstock gas flow channels consist of a flow channel of a first feedstock gas containing the trimethylgallium and the silicon dopant in argon and a flow channel of a second feedstock gas containing the oxygen in argon.
[7] A β-gallium oxide crystalline film, in which a total content of carbon, hydrogen, and nitrogen is 2 × 10¹⁷ cm⁻³ or less, and the β-gallium oxide crystalline film is doped with silicon.
[8] The β-gallium oxide crystalline film according to [7], in which a difference [N_{d} - Nₐ] between a donor concentration N_{d} and an acceptor concentration Nₐ is 10¹⁵ cm⁻³ or more and 10¹⁹ cm⁻³ or less.
[9] The β-gallium oxide crystalline film according to [7] or [8], in which mobility is 30 cm²/Vs or more.

### Advantageous Effects of Invention

According to the method for producing a crystalline film and the vapor phase growth device of the present invention, it is possible to produce a high-purity β-Ga₂O₃ crystalline film. In addition, the β-gallium oxide crystalline film of the present invention has a high purity, and it is expected to realize a high-voltage power device.

### BRIEF DESCRIPTION OF DRAWINGS

[FIG. 1] A schematic front view of a vapor phase growth device of a first embodiment.
[FIG. 2] A schematic top view of a vapor phase growth device of a first embodiment.
[FIG. 3] A schematic front view of a vapor phase growth device of a second embodiment.
[FIG. 4] A diagram showing the results of Experimental Example 1.
[FIG. 5] A diagram showing the results of Experimental Example 4.
[FIG. 6] A diagram showing the results of Experimental Example 5.

### DESCRIPTION OF EMBODIMENTS

### <First Embodiment>

### [Vapor phase growth device]

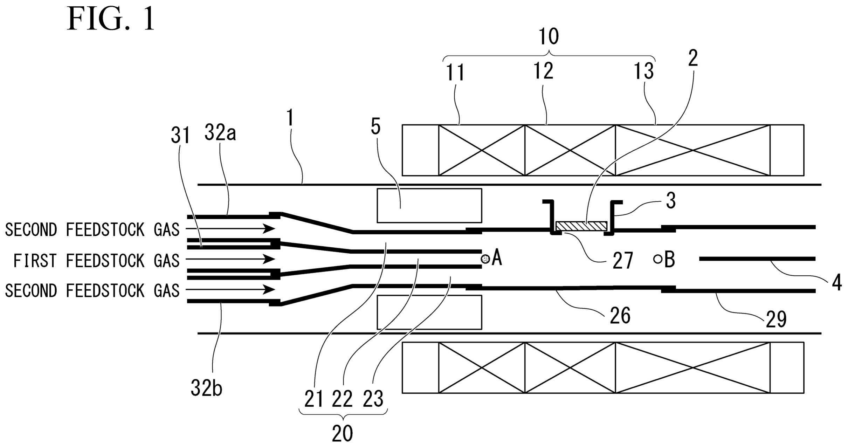

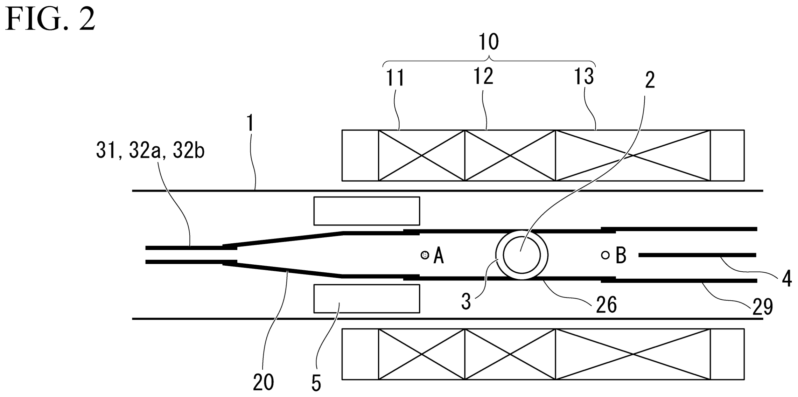

FIG. 1 and FIG. 2 show a vapor phase growth device according to a first embodiment of the present invention. The vapor phase growth device of FIG. 1 is a device for forming a β-gallium oxide crystalline film by a vapor phase growth method, and includes a reaction tube 1 in which a substrate 2 is disposed and a zone heater 10 for heating the reaction tube 1. In the present embodiment, the zone heater 10 corresponds to the heating device according to the embodiment of the present invention. In addition, the reaction tube 1 corresponds to the reaction furnace according to the embodiment of the present invention.

An upstream flow channel 20, an intermediate flow channel 26, and a downstream flow channel 29 are formed in the reaction tube 1. The upstream flow channel 20 corresponds to the feedstock gas flow channel according to the embodiment of the present invention that guides a plurality of feedstock gas to the merging position. In addition, the intermediate flow channel 26 and the downstream flow channel 29 guide the mixed gas from the merging position to the substrate surface and then discharge the mixed gas, which corresponds to the mixed gas flow channel according to the embodiment of the present invention.

In the upstream flow channel 20, three flow channels, a top channel 21, a middle channel 22, and a bottom channel 23, are formed in this order from the top. The middle channel 22 serves as a feedstock gas flow channel that supplies a first feedstock gas to the substrate 2, and the top channel 21 and the bottom channel 23 serve as feedstock gas flow channels that supply a second feedstock gas to the substrate 2.

As shown in FIG. 1 and FIG. 2, the upstream flow channel 20 of the present embodiment has a cross section in a vertical direction that is reduced in diameter from upstream to downstream and a cross section in a horizontal direction that is increased in diameter from upstream to downstream. At the downstream end, the upstream flow channel 20 has a flat shape spread in the horizontal direction, with the first feedstock gas flowing out from the center in the vertical direction and the second feedstock gas flowing out from the upper side and the lower side.

The intermediate flow channel 26 is connected to the downstream side of the upstream flow channel 20, and the connection point, that is, the upstream end of the intermediate flow channel 26 corresponds to a merging position at which a plurality of feedstock gases according to the embodiment of the present invention merge.

At the merging position, the first feedstock gas that has flowed out from the middle channel 22 and the second feedstock gas that has flowed out from the top channel 21 and the bottom channel 23 merge, and the obtained mixed gas flows in the intermediate flow channel 26. A point A indicated by a black circle shown in the drawing is the center of the merging position.

An upper opening part 27 is formed in an upper tube wall of the intermediate flow channel 26, and a hanging type substrate holder 3 is fitted to the upper opening part 27. The hanging type substrate holder 3 includes a plurality of claws that support the substrate 2 on a lower side facing the intermediate flow channel 26. Then, by disposing the substrate 2 on the hanging type substrate holder 3, the lower-side surface of the substrate 2 is exposed to the mixed gas in the intermediate flow channel 26.

By adopting a so-called "face-down type" in which the lower-side surface of the substrate 2 is exposed to the mixed gas, it is easy to avoid unexpected adhesion of particles and the like.

The downstream flow channel 29 is connected to the downstream side of the intermediate flow channel 26, and the mixed gas that has passed through the intermediate flow channel 26 is discharged to the outside of the reaction tube 1 from the downstream side of the downstream flow channel 29.

A feedstock gas supply tube is connected to the upstream side of the upstream flow channel 20. Specifically, the first feedstock gas supply tube 31 is connected to the middle channel 22, and the first feedstock gas is supplied to the middle channel 22. In addition, the second feedstock gas supply tube 32a is connected to the top channel 21, and the second feedstock gas is supplied to the top channel 21. In addition, the second feedstock gas supply tube 32b is connected to the bottom channel 23, and the second feedstock gas is supplied to the bottom channel 23.

The zone heater 10 is provided in an annular shape along the outer wall of the reaction tube 1. The zone heater 10 consists of a heater for upstream heating 11, a heater for intermediate heating 12, and a heater for downstream heating 13, and the heater for upstream heating 11, the heater for intermediate heating 12, and the heater for downstream heating 13 are each configured to have their temperatures set individually.

The heater for upstream heating 11 is disposed around a portion of the outer wall of the reaction tube 1 surrounding the point A, the heater being configured to heat the vicinity of the point A (upstream side portion of the intermediate flow channel 26) where the first feedstock gas and the second feedstock gas merge.

The heater for intermediate heating 12 is disposed around a portion of the outer wall of the reaction tube 1 surrounding a portion of the intermediate flow channel 26 where the upper opening part 27 is provided, the heater being configured to heat a portion where the upper opening part 27 is provided, that is, a portion where the substrate 2 is disposed.

The heater for downstream heating 13 is disposed around a portion of the outer wall of the reaction tube 1 surrounding the downstream side of the portion of the intermediate flow channel 26 where the upper opening part 27 is provided, the heater being configured to heat the downstream flow channel 29 and the downstream side of the portion where the upper opening part 27 is provided.

The downstream side (vicinity of point A) of the upstream flow channel 20 is covered with a heat insulating box 5. The heat insulating box 5 can be configured, for example, by sealing an alumina heat insulating material in an annular box made of quartz and having a hollow inside.

By providing the heat insulating box 5, it is possible to prevent the feedstock gas from being thermally decomposed in the upstream flow channel 20, thereby preventing gallium and the like from adhering to the upstream flow channel 20.

Instead of the heat insulating box 5, a heat insulating mat or the like may be wound on the downstream side of the upstream flow channel 20.

**In** a case where the heat insulating box 5 is used, the heat insulating box 5 can be moved in the flow direction of the feedstock gas while maintaining the overall shape. Therefore, it is easy to adjust the temperature in the vicinity of the point A.

### [Method for producing crystalline film]

To produce a crystalline film using the vapor phase growth device of the first embodiment, the substrate 2 may be suspended by the hanging type substrate holder 3, and the mixed gas may be brought into contact with the lower-side surface of the substrate 2 under predetermined heating conditions.

The substrate 2 is not particularly limited as long as it has a plate shape and can support the crystalline film, and may be a known substrate. The substrate 2 may be an insulating substrate, a conductive substrate, or a semiconductor substrate. In the present embodiment, it is preferable that the substrate be a crystalline substrate.

The crystalline substrate is not particularly limited as long as it is a substrate containing a crystalline material as a main component, and may be a known substrate. The substrate may be an insulating substrate, a conductive substrate, or a semiconductor substrate. The substrate may be a single-crystal substrate or a polycrystalline substrate. Examples of the crystalline substrate include a substrate containing a crystalline material having a corundum structure as a main component, a substrate containing a crystalline material having a β-gallia structure as a main component, and a substrate having a hexagonal crystal structure. The "main component" refers to a component having a composition ratio of 50% or more of the crystalline material in the substrate, and is preferably a component having a composition ratio of 70% or more thereof and more preferably a component having a composition ratio of 90% or more thereof.

Examples of the substrate containing, as a main component, a crystalline material having a corundum structure include a sapphire substrate, an α-type gallium oxide substrate, and the like. Examples of the substrate containing, as a main component, a crystalline material having a β-gallia structure include a β-Ga₂O₃ substrate, a mixed crystal substrate containing β-Ga₂O₃ and Al₂O₃, and the like. In addition, examples of the substrate having a hexagonal crystal structure include a SiC substrate, a ZnO substrate, a GaN substrate, and the like. Examples of other crystalline substrates include a Si substrate and the like.

In the present embodiment, the crystalline substrate is preferably a sapphire substrate. Examples of the sapphire substrate include a c-plane sapphire substrate, an m-plane sapphire substrate, an a-plane sapphire substrate, and the like. In the present embodiment, it is preferable that the crystalline substrate is a c-plane sapphire substrate. In addition, in the present embodiment, the crystalline substrate is also preferably an m-plane sapphire substrate, and the sapphire substrate may have an off angle. The off angle is not particularly limited, but is preferably 0° to 15° in a direction of the a axis or the m axis, or a direction including both the a axis and the m axis. The thickness of the crystalline substrate is not particularly limited, but is preferably 50 to 2,000 µm and more preferably 200 to 800 µm.

The mixed gas contains vaporized trimethylgallium, an oxygen gas, and a silicon dopant gas in argon gas. Trimethylgallium is a source of a gallium atom, oxygen (oxygen molecule) is a source of an oxygen atom, and argon is a carrier. Examples of silicon dopants include monosilane, tetramethylsilane, and tetraethylsilane.

It is preferable that the trimethylgallium and the oxygen contained in the mixed gas be separately supplied to the merging position. As a result, it is possible to avoid the reaction between trimethylgallium and oxygen before merging together.

It is preferable that the trimethylgallium and the silicon dopant be supplied to the merging position in a premixed state. As a result, the supply ratio of the silicon dopant to trimethylgallium can be stably controlled.

In the present embodiment, the first feedstock gas is defined as a "gas containing trimethylgallium and a silicon dopant in argon" and can be supplied to the merging position via the middle channel 22. In addition, the second feedstock gas is defined as a "gas containing oxygen in argon" and can be supplied to the merging position via the top channel 21 and the bottom channel 23.

The supply ratio of the silicon dopant to trimethylgallium may be adjusted depending on the amount of silicon to be doped in the crystalline film, but is preferably 10⁻⁹ to 10⁻⁴ in terms of the molar ratio of silicon to trimethylgallium.

According to the present embodiment, since the unintentional inclusion of silicon as an impurity in the mixed gas can be suppressed, the amount of silicon to be doped can be easily adjusted by the supply ratio of the silicon dopant to trimethylgallium.

The growth temperature, that is, the temperature of the mixed gas in a case of being in contact with the surface of the substrate 2 is preferably 575°C to 1100°C. In a case where the growth temperature is equal to or higher than the preferred lower limit value, the concentration of impurities incorporated into the crystalline film can be reduced.

It is preferable that the growth temperature be substantially constant in the entire range of the upstream surface and the downstream surface of the substrate 2.

The temperature at the point A is preferably 850°C to 1100°C, more preferably 870°C to 1,080°C, still more preferably 890°C to 1,060°C, and particularly preferably 900°C to 1,050°C. In a case where the temperature at the point A is equal to or higher than the preferred lower limit value, the concentration of impurities incorporated into the crystalline film can be reduced. In a case where the temperature at the point A is equal to or lower than the preferred upper limit value, it is possible to avoid exceeding the appropriate growth temperature before coming into contact with the surface of the substrate 2.

The temperature of the mixed gas before coming into contact with the surface of the substrate 2 including the point A is preferably equal to or lower than the growth temperature, and more preferably lower than the growth temperature. As a result, it is possible to prevent the mixed gas before reaching the surface of the substrate 2 from being thermally decomposed, thereby preventing gallium, gallium oxide, and the like from adhering to the upstream flow channel 20 and the upstream side of the intermediate flow channel 26.

It is preferable that the temperature of the mixed gas from the point A until the mixed gas contacts the most upstream side of the surface of the substrate 2 gradually increase.

The temperature in the intermediate flow channel 26, such as the point A, can be confirmed by inserting the thermocouple 4 into the flow channel.

In a case of measuring the temperature at the point A, the tip of the thermocouple 4 is inserted until the tip reaches the position of the point A. In a case of measuring the temperature at the point B (a position indicated by a white circle shown in the drawing), the tip of the thermocouple 4 is inserted until the tip reaches the position of the point B. FIGs. 1 and 2 show a state in which the tip of the thermocouple 4 is retracted to a slightly downstream side of the point B.

However, in a case where the thermocouple 4 is inserted during actual film formation, a problem such as the gallium oxide film adhering to the thermocouple 4 occurs. Therefore, during the measurement by the thermocouple 4, nitrogen containing neither trimethylgallium, a silicon dopant, nor oxygen is flowed. Then, the thermocouple 4 is drawn out of the reaction tube 1 during the film formation.

### <Second embodiment>

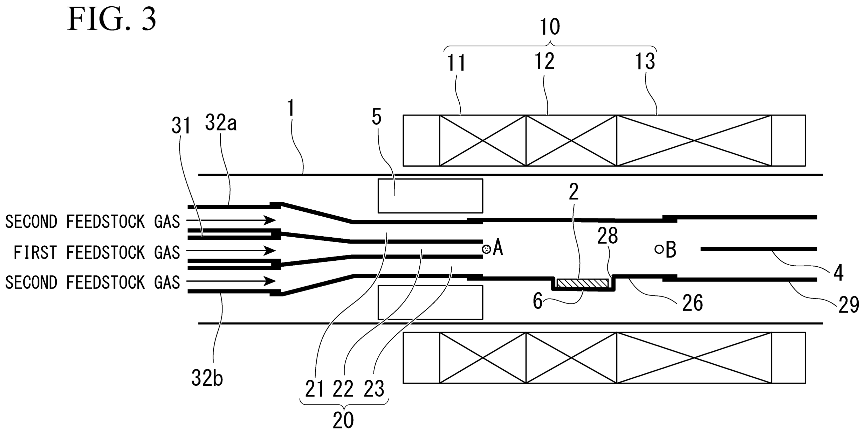

FIG. 3 shows a vapor phase growth device according to a second embodiment of the present invention. The vapor phase growth device of FIG. 3 is the same as that of the first embodiment except that the upper-side surface of the substrate 2 is exposed to the mixed gas, that is, it is a so-called "face-up type". **In** FIG. 3, the same reference numerals as those in FIG. 1 are assigned to the same components as those in the first embodiment, and detailed description thereof will be omitted.

Since the vapor phase growth device of the present embodiment is a so-called face-up type, a lower opening part 28 is formed on a lower tube wall of the intermediate flow channel 26, and the placing type substrate holder 6 is fitted to the lower surface opening part 28.

A recess part is formed on the upper surface of the placing type substrate holder 6, on which the substrate 2 is placed, and the upper-side surface of the substrate 2 is exposed to the mixed gas in the intermediate flow channel 26 by disposing the substrate 2 on the face-up type substrate holder 6.

The method for producing a crystalline film using the vapor phase growth device of the present embodiment is the same as the method for producing a crystalline film using the vapor phase growth device of the first embodiment, except that the substrate 2 is placed on the placing type substrate holder 6.

### <Other embodiments>

In each of the above-described embodiments, the upstream flow channel 20 has a configuration in which a middle channel 22 for supplying the first feedstock gas, and the top channel 21 and the bottom channel 23 for supplying the second feedstock gas are formed. However, a configuration may also be adopted in which a fourth channel for supplying a third feedstock gas is further formed. In that case, the silicon dopant may not be contained in the first feedstock gas, and a gas containing the silicon dopant in argon can be used as the third feedstock gas.

In addition, the device may be configured such that both the hanging type substrate holder 3 and the placing type substrate holder 6 are attached to the intermediate flow channel 26, thereby performing film formation simultaneously by the face-down type method and the face-up type method.

In addition, various modification can be made without departing from the scope of the present invention.

### <Mechanism of action>

According to each of the above-described embodiments, a β-gallium oxide crystalline film having a small amount of impurities can be efficiently obtained. The reason for this is considered as follows.

First, in the above-described embodiment, trimethylgallium is used as the gallium source.

In a case where triethylgallium, instead of trimethylgallium, is used as a gallium source, triethylgallium having a low decomposition temperature easily reacts with silicon dioxide contained in a material (quartz or the like) of a member that comes into contact with a feedstock gas, such as a flow channel. As a result, there is a problem that the silicon generated by thermal decomposition is taken in a large amount into the crystalline film. In addition, since triethylgallium has a low vapor pressure, there is also the problem of difficulty in supplying gallium at a high concentration to a reaction furnace.

In the above-described embodiment, since trimethylgallium having a high decomposition temperature and being difficult to undergo self-thermal decomposition is used as the gallium source, a reaction with quartz or the like is suppressed, and the amount of silicon unintentionally incorporated into the crystalline film can be reduced.

In addition, since trimethylgallium has a high vapor pressure, gallium can be supplied to the reaction furnace at a high concentration, and a crystalline film can be grown at a high speed.

In addition, in a case where an organic metal is generally used as a metal source, carbon and hydrogen derived from a hydrocarbon group tend to be incorporated into the crystalline film.

In each of the above-described embodiments, since the mixed gas is sufficiently heated from the merging position, the hydrocarbon generated by the decomposition of trimethylgallium can be sufficiently reacted with oxygen before reaching the substrate. As a result, it was possible to suppress the incorporation of carbon and hydrogen derived from the hydrocarbon group into the crystalline film.

In the above-described embodiment, argon was used as a carrier. In a case where nitrogen gas is used as a carrier, nitrogen is incorporated into the film and an acceptor is formed. Argon does not form a donor or an acceptor in the film.

As described above, in the above-described embodiment, the amount of impurities unintentionally mixed into the β-gallium oxide crystalline film can be reduced. As a result, by adjusting the supply ratio of the silicon dopant to trimethylgallium, it is possible to stably control the electron concentration in the crystalline film.

In the related art, to prevent the feedstock gas before reaching the substrate from forming a film in the flow channel, the feedstock gas flow channel was cooled by a cooling device. On the other hand, in the above-described embodiment, the mixed gas is not cooled but rather is intentionally heated from the merging position, but the film formation in the flow channel has been sufficiently suppressed for practical purposes. This is considered to be because the hydrocarbon group moiety is more likely to react with oxygen first than the gallium derived from trimethylgallium.

Hereinafter, the crystalline film obtained in the above-described embodiment will be described in detail.

### <Crystalline film>

The crystalline film of the present embodiment is a β-type gallium oxide crystalline film. In the crystalline film of the present embodiment, the total content of carbon, hydrogen, and nitrogen is 2 × 10¹⁷ cm⁻³ or less. The total content of carbon, hydrogen, and nitrogen is preferably 1 × 10¹⁷ cm⁻³ or less and more preferably 1 × 10¹⁶ cm⁻³ or less.

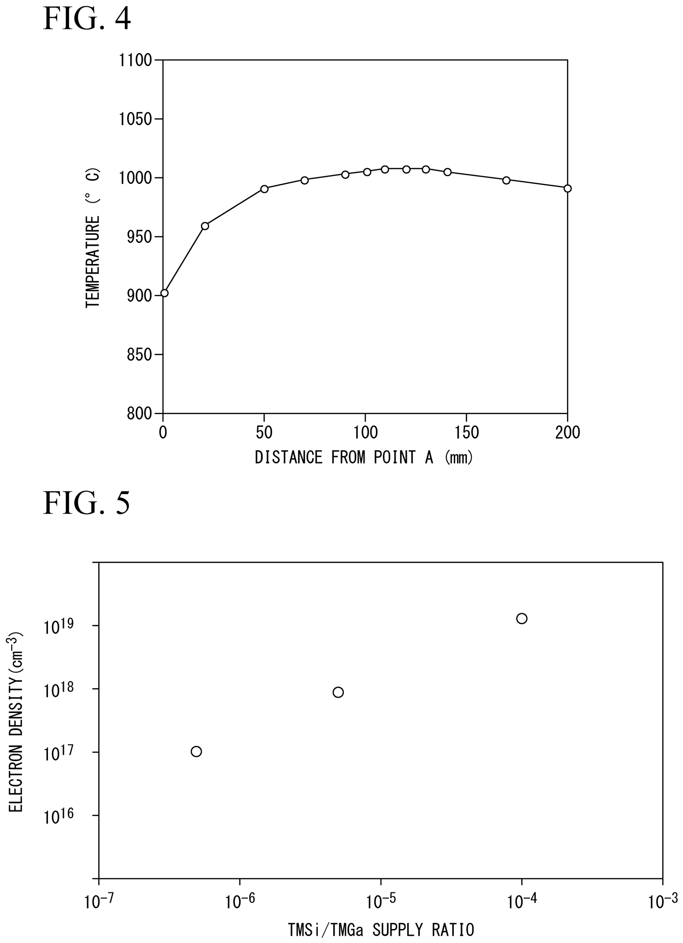

In the present specification and the claims, the unit of a numerical value indicating the content of each atom contained in the crystalline film is described as "cm⁻³". This unit means the number of atoms per 1 cm³, and may be described as "atoms/cm³". The same applies to the electron concentration shown in FIG. 5.

The content of carbon is preferably 1 × 10¹⁷ cm⁻³ or less, more preferably 1 × 10¹⁶ cm⁻³ or less, and still more preferably 1 × 10¹⁵ cm⁻³ or less. The content of hydrogen is preferably 1 × 10¹⁷ cm⁻³ or less, more preferably 1 × 10¹⁶ cm⁻³ or less, and still more preferably 1 × 10¹⁵ cm⁻³ or less. The content of nitrogen is preferably 1 × 10¹⁷ cm⁻³ or less, more preferably 1 × 10¹⁶ cm⁻³ or less, and still more preferably 1 × 10¹⁵ cm⁻³ or less.

The content of silicon that is contained not as a dopant, that is, without being derived from an intentionally used silicon dopant, is preferably 1 × 10¹⁶ cm⁻³ or less and more preferably 1 × 10¹⁵ cm⁻³ or less.

The contents of carbon, hydrogen, nitrogen, and silicon are each average values of concentrations in a range of 1 to 3 µm from the film surface, which are measured by secondary ion mass spectrometry (SIMS).

The crystalline film of the present embodiment is doped with silicon and is n-type.

The difference [N_{d} - Nₐ] between the donor concentration N_{d} and the acceptor concentration Nₐ is 10¹⁵ cm⁻³ or more and 10¹⁹ cm⁻³ or less.

The difference [N_{d} - Nₐ] is an average value of values in a range of 2 to 3 µm from the film surface, which is calculated by capacitance-voltage (C-V) measurement using a mercury probe.

The difference [N_{d} - Nₐ] is preferably 1 × 10¹⁵ cm⁻³ or more and 1 × 10¹⁹ cm⁻³ or less.

The mobility of the crystalline film of the present embodiment is preferably 30 cm²/Vs or more, more preferably 50 cm²/Vs or more, and still more preferably 100 cm²/Vs or more. In a case where the mobility is high, it is possible to suppress power loss during the operation of the semiconductor device.

The thickness of the crystalline film of the present embodiment is preferably 0.5 to 100 µm.

The crystalline film of the present embodiment can be particularly suitably used for a semiconductor device, and is particularly useful for a power device. Examples of the semiconductor device formed using the crystalline film of the present embodiment include transistors such as MIS and HEMT, TFTs, Schottky barrier diodes using semiconductor-metal junctions, PN or PIN diodes in combination with other P layers, and light emitting and light receiving elements. The crystalline film of the present embodiment may be used as it is in a semiconductor device or the like in a state where the crystalline film is formed on a substrate, or may be applied to a semiconductor device or the like after using a known method such as peeling off from a substrate.

The semiconductor device is suitably used as a power module, an inverter, or a converter by using a known unit, and is suitably used for a semiconductor system or the like using, for example, a power supply device.

### Examples

### <Substrate>

The following substrates were used in the Experimental Examples described below.

Substrate A: Sn-doped Ga₂O₃ substrate (manufactured by Novel Crystal Technology, Inc.) having a (010) plane and a thickness of 0.50 mm. Substrate B: sapphire substrate (manufactured by Orbray Co., Ltd.) having a (0001) plane, a thickness of 0.43 mm, and an off angle of 0.15° in the m-axis direction.

### <Feedstock>

The following feedstocks were used in the Experimental Examples described below.
TMGa: trimethylgallium (manufactured by Taiyo Nippon Sanso Corporation).
O₂: oxygen (manufactured by Taiyo Nippon Sanso Corporation).
Ar: Argon (manufactured by Taiyo Nippon Sanso Corporation).
TMSi: tetramethylsilane (manufactured by Taiyo Nippon Sanso Corporation).

### <Measurement method>

The concentrations of carbon, hydrogen, and nitrogen contained as impurities were each measured at a total of 64 points at intervals of 0.031 µm in a range of 1 to 3 µm from the film surface using a secondary ion mass spectrometer IMS-6f type manufactured by CAMECA. The average of the measurement results of 64 points was taken as the content. Using the same device as that used for measuring carbon, hydrogen, and nitrogen, the concentration of silicon contained was measured at a total of 53 points at intervals of 0.038 µm in a range of 1 to 3 µm from the film surface. The average of the measurement results of 53 points was taken as the content.

The difference [N_{d} - Nₐ] was measured at six points at intervals of 0.2 µm in a range of 2 to 3 µm from the film surface using a (C-V) measurement device Model 802B, equipped with a mercury probe, manufactured by MATERIALS DEVELOPMENT CORPORATION. The average of the measurement results at six points was defined as a difference [N_{d} - Nₐ].

The electron concentration and the mobility were determined by AC Hall measurement (alternating current magnetic field method) using ResiTest 8300 manufactured by TOYO Corporation.

The flow rates of Ar, O₂, and TMGa gas were measured by FCS-T1030MZDTC-4J1-F5L-AR-R6-D28, FCS-T1005MZDTC-4J1-F1L-O2-R5-D28, and FCS-T1005MZDTC-4J1-F1L-AR-R4-D28 manufactured by Fujikin Corporation. The pressure after the merging was measured by a diaphragm vacuum gauge. The flow velocity of the mixed gas was calculated from the temperature, pressure, and the flow rate of the mixed gas after merging.

### <Experimental Example 1>

The temperature distribution was confirmed for the same device as that in FIG. 1 except that an alumina heat insulating material having the volume similar to the heat insulating box was wound around the upstream flow channel 20 instead of the heat insulating box 5. The distance from the point A to the point B was set to 200 mm. In addition, the height and the width of the intermediate flow channel 26 were set to 10 mm and 80 mm.

To confirm the temperature distribution using the thermocouple 4, only N₂ was introduced into the device, the flow rate of N₂ supplied from each of the first feedstock gas supply tube 31, the second feedstock gas supply tube 32a, and the second feedstock gas supply tube 32b was 3.0 L/min, the total flow rate was 9.0 L/min, and the pressure after the merging was 1.4 kPa.

As a result, the flow velocity of the mixed gas at a temperature of 1,000°C was 63.2 m/sec, and the time taken for the mixed gas to reach the center of the substrate holder from the point A was 0.0019 seconds.

The set temperature of the zone heater 10 was 600°C for the heater for upstream heating 11 and 960°C for the heater for intermediate heating 12 and the heater for downstream heating 13.

As a result, the temperature distribution shown in FIG. 4 was obtained. As shown in FIG. 4, the temperature at the point A was 903°C, and the temperature near the substrate could be set to a constant temperature of approximately 1,000°C.

### <Experimental Example 2>

Using the same device as in Experimental Example 1, a β-Ga₂O₃ crystalline film having a thickness of 5 µm was grown on the substrate A. The thermocouple 4 was not used.

The gas supplied from the first feedstock gas supply tube 31 was a gas containing TMGa in Ar, and the gas supplied from the second feedstock gas supply tube 32a and the second feedstock gas supply tube 32b was a gas containing O₂ in Ar. TMSi, which is a dopant, was not used.

The supply amount of TMGa was set to 182 µmol/min, and the supply amount of O₂ was set to 178571 µmol/min (2.0 L/min). In this case, the supply ratio of oxygen to trimethylgallium was 981 as a molar ratio of oxygen molecules to trimethylgallium. The growth time was set to 60 minutes. The set temperature of the zone heater 10 was the same as that in Experimental Example 1. The total flow rate of the mixed gas (the total flow rate after merging), the pressure after the merging, the flow velocity of the mixed gas at a temperature of 1,000°C, and the time taken for the mixed gas to reach the center of the substrate holder from the point A were set to 8.4 L/min, 2.4 kPa, 34.4 m/sec, and 0.0035 sec.

In a case where the concentrations of impurities in the obtained crystalline film were measured, the carbon concentration was 3 × 10¹⁶ cm⁻³, the hydrogen concentration was 7 × 10¹⁶ cm⁻³, the nitrogen concentration was 9 × 10¹⁵ cm⁻³, and the silicon concentration was 1 × 10¹⁵ cm⁻³, all of which were extremely low values equivalent to the background level of the SIMS measurement.

The total content of carbon, hydrogen, and nitrogen was 2 × 10¹⁷ cm⁻³ or less.

In addition, the difference [N_{d} - Nₐ] obtained by the (C-V) measurement was 2 × 10¹⁵ cm⁻³. From this, it was confirmed that the impurities were suppressed to an extremely low concentration under the condition that the temperature at the merging position was 903°C.

### <Experimental Example 3>

Using the same device as in Experimental Example 1, a β-Ga₂O₃ crystalline film having a thickness of 5 µm was grown on the substrate shown in Table 1. The thermocouple 4 was not used.

The gas supplied from the first feedstock gas supply tube 31 was a gas containing TMGa in Ar, and the gas supplied from the second feedstock gas supply tube 32a and the second feedstock gas supply tube 32b was a gas containing O₂ in Ar. TMSi, which is a dopant, was not used.

The supply amount of TMGa was set to 182 µmol/min, and the supply amount of O₂ was set to 178571 µmol/min (2.0 L/min). In this case, the supply ratio of oxygen to trimethylgallium was 981 as a molar ratio of oxygen molecules to trimethylgallium. The growth time was set to 60 minutes.

The total flow rate, pressure, and temperature of the mixed gas, the flow velocity of the mixed gas in a case where the temperature was 1,000°C, and the reaching time of the mixed gas from the point A to the center of the substrate holder were changed as shown in Table 1 for each example. The set temperature of the zone heater 10 was the same as that in Experimental Example 1.

As a result of measuring the carbon concentration in the obtained crystalline film, the results in Table 1 were obtained. From this, it was confirmed that under the condition in which the temperature at the merging position was 903°C, in a case where the flow velocity of the mixed gas was reduced and the reaching time from the point A to the center of the substrate was increased, the concentration of impurities was further suppressed.

**[Table 1]**

| Example | Substrate | Total flow rate (L/min) | Pressure (Pa) | Flow velocity (m/sec) | Reaching time (sec) | Carbon concentration (cm⁻³) |
|---|---|---|---|---|---|---|
| 3-1 | Substrate B | 8.4 | 1400 | 59 | 0.0020 | 6 × 10¹⁷ |
| 3-2 | Substrate B | 8.4 | 1900 | 43.5 | 0.0028 | 2 × 10¹⁷ |
| 3-3 | Substrate B | 6.0 | 1400 | 42.2 | 0.0028 | 1 × 10¹⁷ |
| 3-4 | Substrate B | 8.4 | 2400 | 34.4 | 0.0035 | 4 × 10¹⁶ |
| 3-5 | Substrate A | 8.4 | 2400 | 34.4 | 0.0035 | 3 × 10¹⁶ |

### <Experimental Example 4>

Using the same device as in Experimental Example 1, a β-Ga₂O₃ crystalline film having a thickness of 5 µm was grown on the substrate shown in Table 1. The thermocouple 4 was not used.

The gas supplied from the first feedstock gas supply tube 31 was a gas containing TMGa and TMSi in Ar, and the gas supplied from the second feedstock gas supply tube 32a and the second feedstock gas supply tube 32b was a gas containing O₂ in Ar.

By fixing the supply amount of TMGa to 182 µmol/min and changing the supply amount of TMSi, the TMSi/TMGa supply ratio (the supply molar ratio of tetramethylsilane to trimethylgallium) in the first feedstock gas was changed from 9.97 × 10⁻⁵ to 4.98 × 10⁻⁷.

The supply amount of O₂ was set to 178571 µmol/min (2.0 L/min). In this case, the supply ratio of oxygen to trimethylgallium was 981 as a molar ratio of oxygen molecules to trimethylgallium. The growth time was set to 60 minutes. The total flow rate, pressure, and temperature of the mixed gas, the flow velocity of the mixed gas in a case where the temperature was 1000°C, the time taken for the mixed gas to reach the center of the substrate holder from the point A, and the set temperature of the zone heater 10 were the same as those in Experimental Example 1.

FIG. 5 shows the results of measuring the electron concentration of the obtained crystalline film. As shown in FIG. 5, the electron concentration changed linearly depending on the TMSi/TMGa supply ratio.

From this, it was confirmed that the influence of impurities can be suppressed and the electron concentration can be stably controlled by changing the TMSi/TMGa supply ratio under the condition in which the temperature at the merging position is 903°C.

### <Experimental Example 5>

The temperature distribution was confirmed for the same device as that shown in FIG. 1 (the position of the heat insulating box 5 was also the same as that shown in FIG. 1). The distance from the point A to the point B was set to 200 mm. **In** addition, the height and the width of the intermediate flow channel 26 were set to 10 mm and 80 mm.

To confirm the temperature distribution using the thermocouple 4, only N₂ was introduced into the device, the flow rate of N₂ supplied from each of the first feedstock gas supply tube 31, the second feedstock gas supply tube 32a, and the second feedstock gas supply tube 32b was 3.0 L/min, the total flow rate was 9.0 L/min, and the pressure after the merging was 1.4 kPa.

As a result, the flow velocity of the mixed gas at a temperature of 1,000°C was 63.2 m/sec, and the time taken for the mixed gas to reach the center of the substrate holder from the point A was 0.0019 seconds.

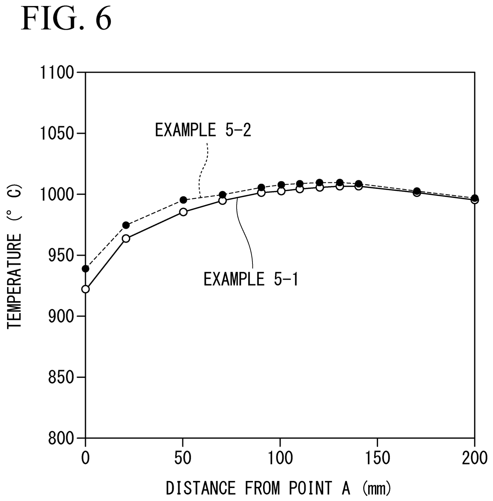

As the set temperature of the zone heater 10, the heater for upstream heating 11 was set to 600°C in Experimental Example 5-1 and 960°C in Experimental Example 5-2. The heater for intermediate heating 12 and the heater for downstream heating 13 were set to 960°C in both Experimental Example 5-1 and Experimental Example 5-2. As a result, the temperature distribution shown in FIG. 6 was obtained. As shown in FIG. 6, the temperature at the point A was 923°C in Experimental Example 5-1 and 939°C in Experimental Example 5-2. The temperature near the substrate could be set to a constant temperature of approximately 1,000°C in both Experimental Example 5-1 and Experimental Example 5-2.

### <Experimental Example 6>

Using the same device as in Experimental Example 1, a β-Ga₂O₃ crystalline film having a thickness of 5 µm was grown on the substrate A. The thermocouple 4 was not used.

The gas supplied from the first feedstock gas supply tube 31 was a gas containing TMGa in Ar, and the gas supplied from the second feedstock gas supply tube 32a and the second feedstock gas supply tube 32b was a gas containing O₂ in Ar. TMSi, which is a dopant, was not used.

The supply amount of TMGa was set to 182 µmol/min, and the supply amount of O₂ was set to 178571 µmol/min (2.0 L/min). In this case, the supply ratio of oxygen to trimethylgallium was 981 as a molar ratio of oxygen molecules to trimethylgallium. The growth time was set to 60 minutes. The set temperature of the zone heater 10 was the same as that of Experimental Example 5-1 in Experimental Example 6-1, and was the same as that of Experimental Example 5-2 in Experimental Example 6-2. The total flow rate of the mixed gas (the total flow rate after merging), the pressure after the merging, the flow velocity of the mixed gas at a temperature of 1000°C, and the time taken for the mixed gas to reach the center of the substrate holder from the point A were set to 8.4 L/min, 1.4 kPa, 59.0 m/sec, and 0.0020 sec.

In a case where the carbon concentration in the obtained crystalline film was measured, the carbon concentration in Experimental Example 6-1 was 6 × 10¹⁷ cm⁻³ and the carbon concentration in Experimental Example 6-2 was 1 × 10¹⁷ cm⁻³.

From this, it was confirmed that in a case where the temperature at the point A was raised from 923°C to 939°C, the carbon concentration could be further suppressed.

### REFERENCE SIGNS LIST

1 Reaction tube
2 Substrate
3 Hanging type substrate holder
4 Thermocouple
5 Heat insulating box
6 Placing type substrate holder
10 Zone heater
11 Heater for upstream heating
12 Heater for intermediate heating
13 Heater for downstream heating
20 Upstream flow channel
21 Top channel
22 Middle channel
23 Bottom channel
26 Intermediate flow channel
27 Upper opening part
28 Lower opening part
29 Downstream flow channel
31 First feedstock gas supply tube
32a Second feedstock gas supply tube
32b Second feedstock gas supply tube

## Claims

1. A method for producing a crystalline film, comprising:
causing a plurality of feedstock gases to merge at a merging position to obtain a mixed gas containing trimethylgallium, oxygen, and a silicon dopant in argon and heating the obtained mixed gas from the merging position; and
guiding the heated mixed gas to a substrate surface to grow a β-gallium oxide crystalline film on the substrate surface.

2. The method for producing a crystalline film according to Claim 1,
wherein the merging position is heated to a temperature of 850°C to 1100°C.

3. The method for producing a crystalline film according to Claim 1 or 2,
wherein the plurality of feedstock gases consists of a first feedstock gas containing the trimethylgallium and the silicon dopant in argon, and a second feedstock gas containing the oxygen in argon.

4. A vapor phase growth device for forming a β-gallium oxide crystalline film by a vapor phase growth method by supplying a mixed gas containing trimethylgallium, oxygen, and a silicon dopant in argon to a substrate disposed in a reaction furnace, the vapor phase growth device comprising:
feedstock gas flow channels configured to respectively guide a plurality of feedstock gases to a merging position and a mixed gas flow channel configured to guide the mixed gas obtained at the merging position from the merging position to a substrate surface and then discharge the mixed gas, the feedstock gas flow channels and the mixed gas flow channel being formed in the reaction furnace; and
a heating device configured to heat the merging position such that a temperature at the merging position is within a range of 850°C to 1100°C.

5. The vapor phase growth device according to Claim 4,
wherein the heating device is disposed around a portion of the reaction furnace surrounding the merging position.

6. The vapor phase growth device according to Claim 4 or 5,
wherein the feedstock gas flow channels consist of a flow channel of a first feedstock gas containing the trimethylgallium and the silicon dopant in argon and a flow channel of a second feedstock gas containing the oxygen in argon.

7. A β-gallium oxide crystalline film,
wherein a total content of carbon, hydrogen, and nitrogen is 2 × 10¹⁷ cm⁻³ or less, and
the β-gallium oxide crystalline film is doped with silicon.

8. The β-gallium oxide crystalline film according to Claim 7,
wherein a difference [N_{d} - Nₐ] between a donor concentration N_{d} and an acceptor concentration Nₐ is 10¹⁵ cm⁻³ or more and 10¹⁹ cm⁻³ or less.

9. The β-gallium oxide crystalline film according to Claim 7 or 8,
wherein mobility is 30 cm²/Vs or more.
